# EUROPEAN PATENT APPLICATION

(11) **EP 0 790 648 A2**
(43) Date of publication of application: **20.08.1997**
(21) Application number: 96119956.9
(22) Date of filing: 12.12.1996
(51) Int. Cl.: H01L 23/498

(54) **Vertical power transistor, circuit and method**

(30) Priority: 15.02.1996 GB 9603186
(71) Applicant: MOTOROLA GmbH, D-65232 Taunusstein (DE)
(72) Inventor: Triantafyllous, Markos, 81929 Munich (DE); Specks, Johannes Will, 81929 Munich (DE)
(74) Representative: Hudson, Peter David

(57) **Abstract**

A semiconductor device such as a vertical power transistor is formed on a semiconductor die. A first conducting electrode and a control electrode are formed on one face of the semiconductor die and a second conducting electrode is formed on a second face of the semiconductor die, the second face being opposite the first face. The first and second faces are then bonded to first and second printed circuit boards respectively.

## Description

### Field of the Invention

This invention relates to semiconductor devices and particularly but not exclusively to vertical power transistor devices.

### Background of the Invention

Vertical power transistors such as vertical MOS (Metal Oxide Semiconductor) transistors are high power devices having source and gate terminals at the top of the device and a drain terminal incorporated in the base of the device. However, the vertical flow of current through the device prevents monolithic integration of transistors with electrically separated drains on a single semiconductor die.

In prior art arrangements, the device is typically mounted on a metal lead frame which is part of a conventional IC package. Bond wires connect the source and gate terminals at the top of the device to the individual leads which form the pins of the package. These leads are designed to be as conductive as possible, so as to reduce R_{ds,on} which is the 'on' resistance across the drain and source terminals. This resistance has an adverse effect on both power efficiency and thermal regulation of the device, since even a small resistance will convert electrical energy to heat energy, an unwanted result in an integrated circuit.

In applications such as automotive components, where car manufacturers are seeking to replace mechanical relays with silicon power transistors, the efficiency and heat problems are further compounded by the need to provide at least four power transistor devices to replace one relay. Since the discrete transistors cannot be integrated on a single semiconductor die because of electrical shorts between the devices, the overall cost of such arrangements, taking into account extra heat sinks and the amount of current required, is prohibitive.

This invention seeks to provide a semiconductor device and a vertical power transistor which mitigate the above mentioned disadvantages.

### Summary of the Invention

According to a first aspect of the present invention there is provided a semiconductor device comprising: a semiconductor die having first and second opposing faces, the first and the second face having first and second sets of electrodes respectively; and first and second printed circuit boards having respective first and second conductive pads connected to the first and second sets of electrodes respectively.

According to a second aspect of the present invention there is provided a vertical power transistor comprising first and second conducting electrodes and a control electrode and formed on a semiconductor die; the first conducting electrode and the control electrode being formed on one face of the semiconductor die and the second conducting electrode being formed on a second face of the semiconductor die, opposite the first face, wherein the first and second faces are arranged for bonding to first and second printed circuit boards respectively.

According to a third aspect of the present invention there is provided a circuit comprising a plurality of semiconductor devices, each device comprising first and second sets of electrodes formed on first and second faces of each semiconductor device, wherein the first and second faces are bonded to first and second printed circuit boards respectively.

Preferably the circuit further comprises bridge elements bonded between the first and second printed circuit boards, and a further semiconductor device coupled to only one of the first and second printed circuit boards.

The plurality of integrated circuits are preferably four transistors arranged as an H-bridge driver circuit, the transistors being preferably formed in MOS technology.

According to a fourth aspect of the present invention there is provided a method for producing a semiconductor device comprising the steps of: preparing areas on a first side of a semiconductor die corresponding to first electrodes of the semiconductor device; preparing areas on a second side the semiconductor die corresponding to second electrodes of the semiconductor device; metallising the prepared areas of the first and second sides of the semiconductor die to form pads; forming bumps on the pads of the first and second sides; and, bonding the first and second sides of the semiconductor die to first and second printed circuit boards respectively, via the bumps.

Preferably the first and second printed circuit boards are bonded with an anisotropic thermoplast. The bumps are preferably formed with a nickel-gold electroless deposition process.

In this way a power transistor is provided which improves efficiency and mitigates heat problems, whilst positively impacting the overall cost of producing such a transistor.

### Brief Description of the Drawings

An exemplary embodiment of the invention will now be described with reference to the drawings in which:
FIG.1 shows a prior art power transistor mounted on a metal lead frame.
FIG.2 shows a vertical power transistor in accordance with a first aspect of the invention.
FIG.3 shows a circuit in accordance with a second aspect of the invention.
FIG.4 shows a circuit in accordance with a third aspect of the invention.

### Detailed Description of a Preferred Embodiment

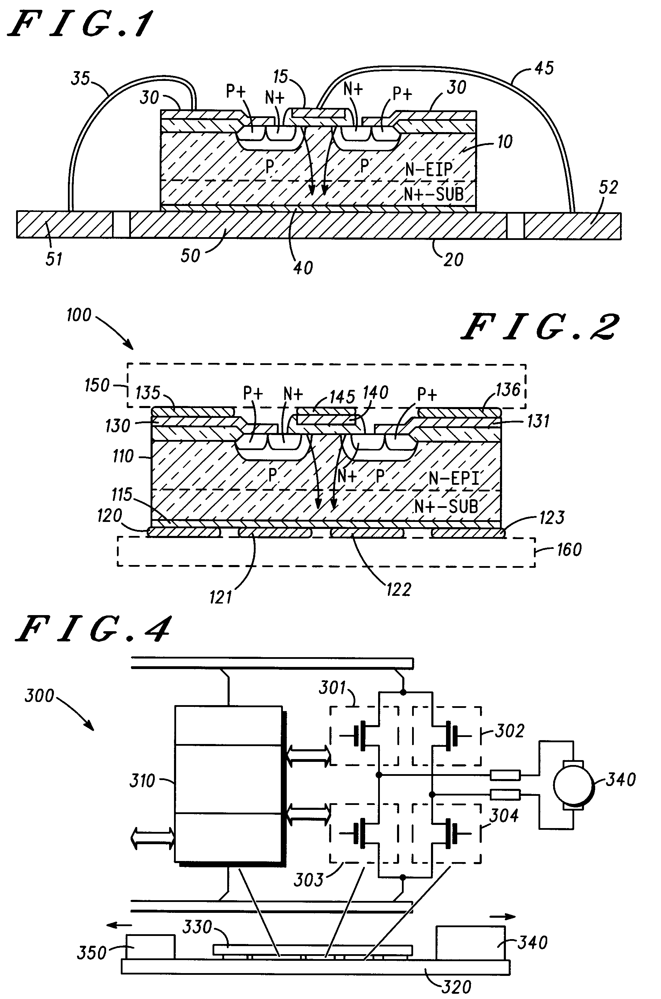

Referring to FIG.1, there is shown a prior art vertical power transistor having gate, source and drain electrodes 15, 30 and 40 respectively, formed in MOS technology. A silicon die 10 incorporating the vertical power transistor is mounted on a flag 50 of the metal lead frame 20. The interface between the die 10 and the flag 50 provides connectivity of the flag 50 to the drain electrode 40. Source electrode 30 and gate electrode 15 are coupled to leads 51 and 52 of the lead frame 20 via bond wires 35 and 45 respectively. The leads 51 and 52 and flag 50 thus form electrically isolated source, gate and drain pins of the integrated circuit package.

The bond wire 35 is designed with a suitable size and length to adequately convey current between the lead 51 and the electrode 30. However, the inherent impedance of the leads and the bond wires contributes to the overall R_{ds,on} the 'on' resistance across the drain and source terminals. In this way the bond wire 35 negatively impacts the overall power efficiency of the transistor, and furthermore significantly affect thermal efficiency.

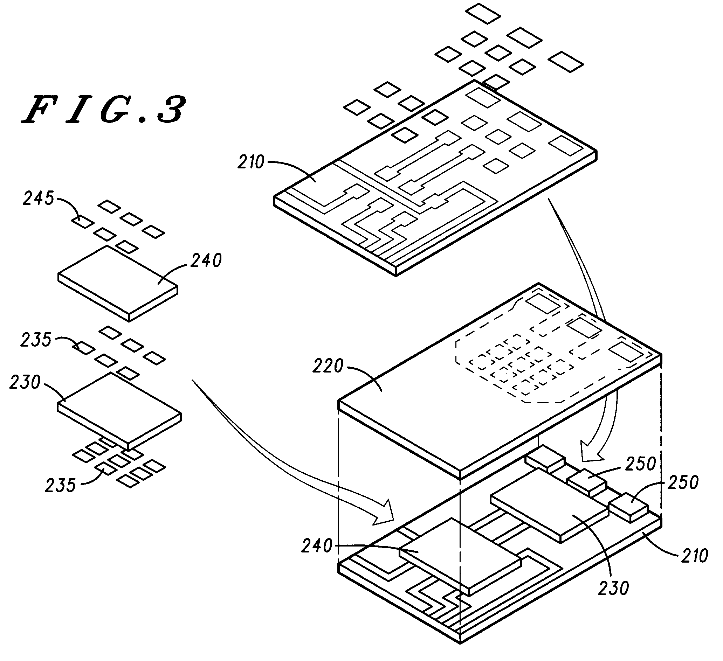

Referring now to FIG.2, there is shown an MOS vertical power transistor device 100, comprising an n-type silicon die 110 which includes p, p+ and n+ wells, and a n+ sub layer. The p, p+ and n+ wells are arranged to define first and second source terminals 130 and 131 respectively and one gate terminal 140 at the top of the die. A nickel-gold bump 135 is electrolessly deposited to the first source terminal 130. Similarly nickel-gold bumps 136 and 145 are electrolessly deposited on the second source terminal 131 and to the gate terminal 140.

A drain terminal 115 is effectively formed in the n+ sub layer. A series of nickel bumps 120, 121, 122 and 123 are electrolessly coupled to the n+ sub layer.

A first PCB (printed circuit board) 150 is coupled to the nickel bumps 135, 136 and 145 at the top of the silicon die 110. The first PCB 150 has isolated tracks and regions (not shown) arranged in conjunction with the relative positions of the nickel bumps 135, 136 and 145, such that source and gate terminal paths in the PCB 150 connect exclusively to the source and gate terminals 130, 131 and 140.

Similarly the second PCB 160 has isolated tracks and regions (not shown) arranged in conjunction with the relative positions of the nickel bumps 120, 121, 122 and 123. In this way a drain terminal path within the second PCB 160 is exclusively coupled to the drain terminal 115.

Referring now also to FIG.3, there is shown an integrated circuit arrangement 200 of first and second PCB's 210 and 220. A double sided MOS device 230 according to the invention has nickel bumps 235 bonded to both sides of the device. A conventional MOS device 240 has nickel-gold bumps 245 bonded to one side of the device. The MOS device 230 and the conventional MOS device 240 are then mounted on the first PCB 210 in a flip-chip fashion, along with bridges 250, which also have nickel bumps on both sides.

Then the second PCB 220 is bonded to the nickel bumps 235 on the exposed face of the MOS device 230, and to the nickel bumps on the exposed faces of the bridges 250. This then forms a PCB sandwich. The first and second PCB's 210 and 220 may be bonded with an anisotropic thermoplast, which also serves as an underfilling material.

Referring now also to FIG.4, there is shown an exemplary embodiment of an H-bridge driver circuit 300 comprising two PCB's 320 and 330 arranged as a flip-chip sandwich. Four MOS vertical power transistors 301, 302, 303 and 304 are arranged as an H-bridge, and bonded to each PCB 320 and 330, as are a number of bridge elements. An integrated circuit 310 is bonded to the PCB 320 only. A DC motor 340 and a bus connector 350 are also bonded to the PCB 320. The PCB 320 contains a number of interconnects (not shown) which connect the devices bonded thereto. The integrated circuit 310 comprises control logic for controlling the circuit and communication logic for sending and receiving control signals to and from the bus connector 350. In this way the driver circuit 300 is able to drive the DC motor 340 in response to signals received at the bus connector 350, without the need for a relay circuit or similar prior art arrangement.

It will be appreciated by a person skilled in the art that alternative embodiments to the one described above are possible. For example, the vertical power transistor could be replaced by any vertical semiconductor element. The n-epi die 110 could be replaced by a p-epi die, with corresponding changes to the wells and other regions. The H-bridge arrangement of FIG.4 is exemplary, and other arrangements of power transistor circuits, such as a full bridge driver circuit having six transistors to implement three branches together with suitable logic are envisaged.

## Claims

1. A semiconductor device comprising: a semiconductor die having first and second opposing faces, the first and the second face having first and second sets of electrodes respectively; and first and second printed circuit boards having respective first and second conductive pads connected to the first and second sets of electrodes respectively.

2. A vertical power transistor comprising first and second conducting electrodes and a control electrode and formed on a semiconductor die; the first conducting electrode and the control electrode being formed on one face of the semiconductor die and the second conducting electrode being formed on a second face of the semiconductor die, opposite the first face, wherein the first and second faces are arranged for bonding to first and second printed circuit boards respectively.

3. A circuit comprising a plurality of semiconductor devices, each device comprising first and second sets of electrodes formed on first and second faces of each semiconductor device, wherein the first and second faces are bonded to first and second printed circuit boards respectively.

4. The circuit of claim 3 further comprising bridge elements bonded between the first and second printed circuit boards.

5. The circuit of claim 3 or claim 4 further comprising a further semiconductor device coupled to only one of the first and second printed circuit boards.

6. The circuit of claim 3, 4 or 5 wherein the plurality of integrated circuits are four transistors arranged as an H-bridge driver circuit.

7. The vertical power transistor of claim 2 or circuit of claims 3, 4, 5 or 6 wherein the transistors are formed in MOS technology.

8. A method for producing a semiconductor device comprising the steps of:
preparing areas on a first side of a semiconductor die corresponding to first electrodes of the semiconductor device;
preparing areas on a second side the semiconductor die corresponding to second electrodes of the semiconductor device;
metallising the prepared areas of the first and second sides of the semiconductor die to form pads;
forming bumps on the pads of the first and second sides; and,
bonding the first and second sides of the semiconductor die to first and second printed circuit boards respectively, via the bumps.

9. The method of claim 8 wherein the first and second printed circuit boards are bonded with an anisotropic thermoplast.

10. The method of claim 8 or claim 9 wherein the bumps are formed with a nickel-gold electroless deposition process.

11. A semiconductor device substantially as hereinbefore described and with reference to the drawing of FIG 2.

12. A circuit substantially as hereinbefore described and with reference to the drawing of FIG 3.

13. A circuit substantially as hereinbefore described and with reference to the drawing of FIG 3.
